# EUROPEAN PATENT APPLICATION

(11) **EP 4 787 621 A1**
(43) Date of publication of application: **05.08.2026**
(21) Application number: 25815437.6
(22) Date of filing: 30.06.2025
(51) Int. Cl.: H01Q 1/38

(54) **ANTENNA, MANUFACTURING METHOD THEREFOR, AND TERMINAL DEVICE**

(30) Priority: 28.05.2024 CN 202410677991
(71) Applicant: HUAWEI TECHNOLOGIES CO., LTD., Shenzhen 518129 (CN)
(72) Inventor: ZHANG, Shijun, Shenzhen, Guangdong 518129 (CN); TIAN, Feng, Shenzhen, Guangdong 518129 (CN); HE, Bo, Shenzhen, Guangdong 518129 (CN); TANG, Wei, Shenzhen, Guangdong 518129 (CN); LI, Heng, Shenzhen, Guangdong 518129 (CN); LI, Siting, Shenzhen, Guangdong 518129 (CN); WANG, Chunhui, Shenzhen, Guangdong 518129 (CN)
(74) Representative: Goddar, Heinz J.
(86) International application number: PCT/CN2025/106197
(87) International publication number: WO 2025/247420

(57) **Abstract**

An antenna, an antenna production method, and a terminal device are provided. An antenna includes a substrate and a radiator. The radiator includes copper plating and a passivation layer. The copper plating is formed on a surface of the substrate, and the passivation layer is provided on a surface of a side that is of the copper plating and that faces away from the substrate. The passivation layer can provide protective effect for the copper plating, reducing a risk that the copper plating is corroded, and improving reliability of the antenna. In addition, because the layers of the radiator are of a simple structure, a process for producing the antenna is significantly simplified, and costs for producing the antenna are also reduced.

## Description

### CROSS-REFERENCE TO RELATED APPLICATIONS

This application claims priority to Chinese Patent Application No. 202410677991.0, filed with the China National Intellectual Property Administration on May 28, 2024 and entitled "ANTENNA, ANTENNA PRODUCTION METHOD, AND TERMINAL DEVICE", which is incorporated herein by reference in its entirety.

### TECHNICAL FIELD

This application relates to the field of communication technologies, and in particular, to an antenna, an antenna production method, and a terminal device.

### BACKGROUND

An antenna based on a laser-direct-structuring (laser-direct-structuring, LDS) technology is formed by employing a laser technology to perform electroless plating directly on molded plastic to form a metal antenna pattern, offering advantages such as being small in volume and flexible in design. Therefore, the LDS antenna is increasingly being used in terminal devices, to support the terminal devices to implement communication functions.

A general procedure for producing an LDS antenna is as follows: performing injection molding to obtain plastic of a specific shape; irradiating a surface of the plastic with a laser, to obtain an activated region of a specific shape; then performing electroless copper plating in the activated region, to form copper plating; and then plating the copper plating with nickel and gold sequentially. After nickel plating, the antenna can be elastically connected to a spring directly, and after gold plating, the antenna can be soldered to a cable or another component. However, a nickel plating process and a gold plating process for the LDS antenna are complex and costly. As a result, the LDS antenna is limited in terminal devices to some extent.

### SUMMARY

This application provides an antenna, an antenna production method, and a terminal device, to simplify an antenna production process and reduce antenna production costs while ensuring that the antenna is corrosion-resistant.

According to a first aspect, this application provides an antenna. The antenna includes a substrate and a radiator. The radiator includes copper plating and a passivation layer. The copper plating may be formed on a surface of the substrate. The passivation layer is provided on a surface of a side that is of the copper plating and that faces away from the substrate. Based on this design, the passivation layer can provide protective effect for the copper plating, reducing a risk that the copper plating is corroded, and improving reliability of the antenna. In addition, compared with a manner of plating the copper plating with nickel and gold in the conventional technology, a manner in this embodiment of this application is performing passivation treatment on the surface of the copper plating to obtain the passivation layer. Therefore, a process for producing the antenna is significantly simplified, and costs for producing the antenna are also reduced.

In some implementations, a material of the substrate may be, but is not limited to, plastic such as polyamide, polycarbonate, or polyester. The plastic includes an organometallic compound. After the surface of the substrate is irradiated by a laser, the organometallic compound in an irradiated region releases metal particles. In this way, the irradiated region becomes an activated region. The copper plating is formed in the activated region.

In some implementations, electrically conductive foam may be disposed on a surface of a side that is of the radiator and that faces away from the substrate, and a region in which the radiator and the electrically conductive foam are in contact with each other is electrically conductive. In this way, after the antenna is mounted in a terminal device in which the antenna is used, the radiator may be electrically connected to a ground component inside the terminal device via the electrically conductive foam. As such, the antenna is grounded.

In some implementations, the surface of the side that is of the copper plating and that faces away from the substrate may exhibit an uneven condition on a microscopic scale. The surface of the side that is of the copper plating and that faces away from the substrate includes a plurality of protrusions and a plurality of recesses formed between adjacent protrusions. Therefore, after the passivation layer is formed on the surface of the copper plating, a thickness of the passivation layer in a region corresponding to the protrusion is less than a thickness of the passivation layer in a region corresponding to the recess. Due to this structure, the passivation layer in the region corresponding to the protrusion can be easily worn through by the electrically conductive foam, exposing the underlying copper plating that can conduct electricity, whereas the passivation layer in the region corresponding to the recess can be well attached to the copper plating due to a large thickness, providing protective effect. Therefore, in the region in which the radiator is in contact with the electrically conductive foam, some portions that are of the copper plating and that are exposed because the passivation layer is worn through can be utilized to implement conduction of electricity, and protection provided by the passivation layer for remaining portions of the copper plating can also be ensured, implementing a balance between corrosion resistance and conduction of electricity of the radiator.

In some implementations, surface roughness of the surface of the side that is of the copper plating and that faces away from the substrate is greater than or equal to 1 um. It is verified that the copper plating meeting the surface roughness condition can not only enable the passivation layer formed subsequently to resist corrosion, but also ensure that resistance of the surface of the radiator is low, balancing corrosion resistance and conduction of electricity of the radiator.

In some implementations, a thickness of the passivation layer is greater than or equal to 50 nm and less than or equal to 1000 nm. For example, a thickness of the passivation layer in a region corresponding to a protrusion may be approximately 50 nm or slightly greater than 50 nm, and a thickness of the passivation layer in a region corresponding to a recess may be approximately 1000 nm or slightly less than 1000 nm. In this way, it can be ensured that conduction of electricity is implemented because the passivation layer in a region corresponding to a protrusion is easy to wear through, and it can also be ensured that the passivation layer in a region corresponding to a recess can implement corrosion resistance due to a relatively large thickness.

In some implementations, the antenna further includes a coaxial cable. The radiator includes a feed point and a ground point that are provided on the copper plating, the feed point is electrically connected to one end of an inner conductor of the coaxial cable, and the ground point is electrically connected to one end of an outer conductor of the coaxial cable. After the antenna is mounted in the terminal device, the other end of the inner conductor of the coaxial cable is connected to a radio frequency chip in the terminal device, and the other end of the outer conductor of the coaxial cable is grounded. In this way, the coaxial cable can be utilized to transfer radio frequency signals between the radio frequency chip and the antenna.

In some implementations, the passivation layer is an organic solderability preservative. The organic solderability preservative has features such as oxidation resistance, thermal shock resistance, and moisture resistance, and can provide effective corrosion resistance for the copper plating.

When the passivation layer is the organic solderability preservative, the one end of the inner conductor of the coaxial cable is soldered to a region that is of the passivation layer and that is opposite a position of the feed point, and the other end of the outer conductor of the coaxial cable is soldered to a region that is of the passivation layer and that is opposite a position of the ground point. Because the organic solderability preservative can easily melt into solder paste during soldering, the inner conductor and outer conductor of the coaxial cable may be soldered to the passivation layer separately. After the passivation layer melts, the inner conductor of the coaxial cable can be reliably connected to the feed point, and the outer conductor of the coaxial cable can be reliably connected to the ground point.

In some implementations, the passivation layer is a chemical conversion coating. A protective function of the chemical conversion coating mainly relies on converting chemically active metal into a chemically inactive metal compound, providing protective effect for the copper plating.

When the passivation layer is the chemical conversion coating, the passivation layer may include a first hollowed-out region and a second hollowed-out region. The first hollowed-out region may be used to expose the feed point, and the second hollowed-out region may be used to expose the ground point. The inner conductor of the coaxial cable may be soldered directly to the feed point, and the outer conductor of the coaxial cable may be soldered directly to the ground point, enabling the coaxial cable to be reliably connected to the radiator.

For example, the first hollowed-out region and the second hollowed-out region may be formed through processes such as grinding, sandblasting, and laser engraving.

In some implementations, the antenna further includes a first adhesive body and a second adhesive body. The first adhesive body coats a solder joint between the inner conductor of the coaxial cable and the feed point, and the second adhesive body coats a solder joint between the outer conductor of the coaxial cable and the ground point. The first adhesive body and the second adhesive body can provide protective effect for the corresponding solder joints respectively, improving reliability of connection between the coaxial cable and the radiator, and further improving operational reliability of the antenna.

In some implementations, the surface of the side that is of the radiator and that faces away from the substrate is copper red.

According to a second aspect, this application provides a terminal device. The terminal device includes a housing and a radio frequency module disposed in the housing. The radio frequency module includes a radio frequency chip and the antenna according to any one of the implementations of the first aspect. The radio frequency chip is connected to the radiator. The radio frequency chip is configured to implement mutual conversion between digital signals and radio frequency signals, while the antenna is configured to send and receive radio frequency signals, enabling the terminal device to implement communication functions.

In some implementations, the housing is provided with one or more air vents. The antenna is disposed at the air vent. The substrate may be provided with one or more openings. At least one of the openings communicates with at least one of the air vents, so that the inside of the housing can communicate with the outside of the housing through the opening and the air vent, implementing air circulation between the inside and outside of the housing, and improving heat dissipation performance of the terminal device.

In some implementations, the copper plating may cover the entire surface of the substrate except an inner wall of the opening. In this way, through proper design of a size of the opening, the opening may be used as a resonant cavity for feeding. Therefore, the antenna provided in this application may be used as a cavity antenna. The cavity antenna has a low loss and offers advantages such as high radiation efficiency and stable performance, helping improve communication performance of the terminal device.

According to a third aspect, this application further provides an antenna production method. The production method includes: forming a radiator on a surface of a substrate. Forming the radiator on the surface of the substrate may include the following steps:
forming copper plating on the surface of the substrate; and
forming a passivation layer on a surface of a side that is of the copper plating and that faces away from the substrate.

For an antenna produced by using the foregoing method, the passivation layer covers the copper plating. Therefore, the passivation layer can provide protective effect for the copper plating, reducing a risk that the copper plating is corroded, and improving reliability of the antenna. In addition, compared with a manner of plating the copper plating with nickel and gold in the conventional technology, a manner in this embodiment of this application is performing passivation treatment on the surface of the copper plating to obtain the passivation layer. Therefore, a process for producing the antenna is significantly simplified, and costs for producing the antenna are also reduced.

In some implementations, before forming the copper plating on the surface of the substrate, the production method further includes:
performing injection molding to form the substrate, and performing laser engraving on the surface of the substrate to form an activated region. The copper plating is formed in the activated region.

In some implementations, forming the passivation layer on the surface of the side that is of the copper plating and that faces away from the substrate specifically includes:
immersing the substrate on which the copper plating is formed in an organic solderability solvent, to form an organic solderability preservative on the surface of the side that is of the copper plating and that faces away from the substrate.

In some implementations, after forming the organic solderability preservative on the surface of the side that is of the copper plating and that faces away from the substrate, the production method further includes:
soldering one end of an inner conductor of a coaxial cable to a region that is of the organic solderability preservative and that is opposite a position of a feed point on the copper plating, and soldering one end of an outer conductor of the coaxial cable to a region that is of the organic solderability preservative and that is opposite a position of a ground point on the copper plating. The organic solderability preservative provides good solderability. In a case of low-temperature solder paste or normal-temperature solder paste, the regions that are of the organic solderability preservative and that are opposite the positions of the feed point and the ground point can melt into the solder paste, enabling the coaxial cable to be reliably connected to the radiator.

In some implementations, forming the passivation layer on the surface of the side that is of the copper plating and that faces away from the substrate specifically includes: immersing the substrate on which the copper plating is formed in a passivation solution, to form a chemical conversion coating on the surface of the side that is of the copper plating and that faces away from the substrate.

In some implementations, after forming the chemical conversion coating on the surface of the side that is of the copper plating and that faces away from the substrate, the production method further includes:
forming a first hollowed-out region and a second hollowed-out region in the chemical conversion coating, where the first hollowed-out region is used to expose a feed point, and the second hollowed-out region is used to expose a ground point; and soldering one end of an inner conductor of a coaxial cable to the feed point, and soldering one end of an outer conductor of the coaxial cable to the ground point, enabling the coaxial cable to be reliably connected to the radiator.

### BRIEF DESCRIPTION OF DRAWINGS

FIG. 1 is a diagram of a structure of a terminal device according to an embodiment of this application;
FIG. 2 is a diagram of a partial structure of the terminal device according to an embodiment of this application;
FIG. 3 is a partial section of the terminal device shown in FIG. 2 at A-A;
FIG. 4 is a diagram of a structure of an antenna according to an embodiment of this application;
FIG. 5 is a partial section of the antenna shown in FIG. 4 at B-B;
FIG. 6 is a partial enlarged view of a region C in FIG. 4;
FIG. 7 is a diagram of a structure of a surface of a side that is of copper plating and that faces away from a substrate under an electron microscope according to an embodiment of this application;
FIG. 8 is a diagram of a section structure of a radiator test sample under an electron microscope according to an embodiment of this application;
FIG. 9 is a flowchart of an antenna production method according to an embodiment of this application; and
FIG. 10 is a flowchart of another antenna production method according to an embodiment of this application.

Reference numerals:
1000-terminal device; 100-housing; 110-first housing; 120-second housing; 121-air vent; 122-air passage; 200-keyboard;
300-display; 400-heat dissipator; 500-antenna; 510-substrate; 511-opening; 512-mounting ear; 520-radiator; 521-copper plating;
5211-feed point; 5212-ground point; 522-passivation layer; 5221-first hollowed-out region; 5222-second hollowed-out region; 530-coaxial cable;
540-electrically conductive foam.

### DESCRIPTION OF EMBODIMENTS

To make objectives, technical solutions, and advantages of this application clearer, the following further describes embodiments of this application in detail with reference to the accompanying drawings. However, example implementations can be implemented in a plurality of forms, and should not be construed as being limited to implementations described herein. Identical reference numerals in the accompanying drawings denote identical or similar structures. Therefore, repeated descriptions thereof are omitted. Expressions of positions and directions in embodiments of this application are all described by using the accompanying drawings as examples. However, changes may also be made as required, and all the changes fall within the protection scope of this application. The accompanying drawings in embodiments of this application are merely used to illustrate relative positional relationships and do not represent actual scales.

It should be noted that specific details are set forth in the following descriptions to facilitate understanding of this application. However, embodiments of this application can be implemented in a plurality of manners different from those described herein, and a person skilled in the art can perform similar promotion without departing from connotation of embodiments of this application. Therefore, this application is not limited to specific implementations disclosed below.

A terminal device in embodiments of this application is a device with a communication function, and may be specifically a terminal device employing one or more of the following communication technologies: Bluetooth (Bluetooth, BT) communication technology, global positioning system (global positioning system, GPS) communication technology, wireless fidelity (wireless fidelity, Wi-Fi) communication technology, global system for mobile communications (global system for mobile communications, GSM) communication technology, wideband code division multiple access (wideband code division multiple access, WCDMA) communication technology, long term evolution (long term evolution, LTE) communication technology, 5G communication technology, other future communication technologies, and the like. The terminal device in embodiments of this application may include a mobile terminal or a fixed terminal. For example, the mobile terminal may be a notebook computer, a tablet computer, a mobile phone, a smart band, a smart watch, a smart helmet, smart glasses, or the like; and the fixed terminal may be a router, a smart TV, a smart home device, a smart speaker, a desktop computer, or the like. In addition, the terminal device may alternatively be a handheld device or computing device with a wireless communication function, another processing device or vehicle-mounted device connected to a wireless modem, a terminal device in a 5G network, a terminal device in a future evolved public land mobile network (public land mobile network, PLMN), or the like. This is not limited in embodiments of this application.

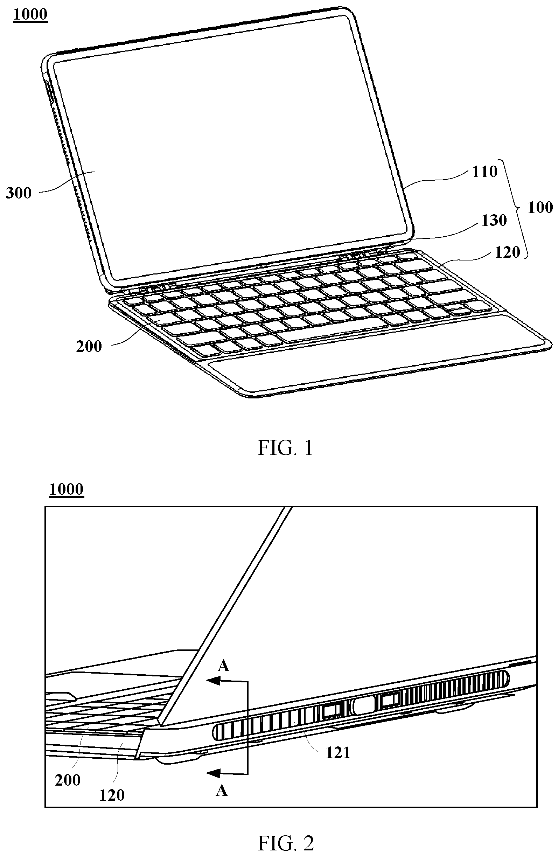

FIG. 1 is a diagram of a structure of a terminal device 1000 according to an embodiment of this application. An example is used for description, in which the terminal device 1000 in the embodiment shown in FIG. 1 is a notebook computer. As shown in FIG. 1, the terminal device 1000 includes a housing 100 and a radio frequency module (not shown in the figure), with the radio frequency module disposed in the housing 100. The radio frequency module is configured to modulate digital signals into radio frequency signals and radiate the radio frequency signals to the outside, and configured to modulate radio frequency signals received from the outside into digital signals. In this way, the terminal device implements signal transmission and reception functions. The radio frequency module may include a radio frequency chip and an antenna, with the radio frequency chip electrically connected to the antenna. The radio frequency chip is configured to implement mutual conversion between digital signals and radio frequency signals. The antenna is configured to send and receive radio frequency signals.

In addition, the radio frequency module may further include components such as a radio frequency amplifier, a filter, a frequency mixer, and a frequency synthesizer that are connected between the radio frequency chip and the antenna, so that the radio frequency module implements functions such as signal amplification, frequency conversion, and frequency synthesis, to guarantee reliability and stability of signal communication.

In some embodiments, the housing 100 includes a first housing 110 and a second housing 120. The first housing 110 and the second housing 120 are rotatably connected by a rotating shaft mechanism 130, allowing the first housing 110 to be able to fit onto the second housing 120 to close the terminal device 1000, or allowing the first housing 110 to rotate to a specific angle relative to the second housing 120 to meet a user's use requirement. In addition, the terminal device 1000 further includes a keyboard 200 and a display 300. The keyboard 200 may be configured to implement an input function of the terminal device 1000. The display 300 may be configured to implement a display function, and may display content entered by using the keyboard. The display 300 is disposed in the first housing 110. The keyboard 200 is disposed in the second housing 120. When the terminal device 1000 is in a closed state, the display 300 and the keyboard 200 may be hidden between the first housing 110 and the second housing 120.

In this embodiment, an accommodating space may be formed between the display 300 and the first housing 110, and an accommodating space may also be formed between the keyboard 200 and the second housing 120. In the accommodating space formed between the display 300 and the first housing 110 and/or the accommodating space formed between the keyboard 200 and the second housing 120, components of the terminal device 1000 such as a circuit board, a battery, a speaker, and a heat dissipation module may be mounted. The circuit board may house all or some of components of a main controller, of a storage unit, of a power management module, and of the radio frequency module of the terminal device. The battery may supply power to the display, the speaker, and components. The heat dissipation module may dissipate heat for components that require heat dissipation.

FIG. 2 is a diagram of a partial structure of the terminal device 1000 according to an embodiment of this application. As shown in FIG. 1 and FIG. 2, in an implementation, the circuit board, the battery, and the heat dissipation module may be disposed in the accommodating space formed between the keyboard 200 and the second housing 120. In this case, the second housing 120 may be provided with one or more air vents 121. The accommodating space may communicate with the outside through the one or more air vents 121 separately, so that hot air in the accommodating space is discharged to the outside and cold air from the outside enters the accommodating space through the air vents 121, implementing heat dissipation for components in the accommodating space.

During specific implementation, the air vents 121 may be classified into air inlets and air outlets, and an air passage may be formed between the air inlets and the air outlets. Air from the outside may enter the air passage through the air inlets, and be discharged through the air outlets after heat exchange is completed in the air passage. The air inlets and the air outlets may be provided in a same side wall of the second housing 120 or in different side walls of the second housing 120. This is not limited in this application.

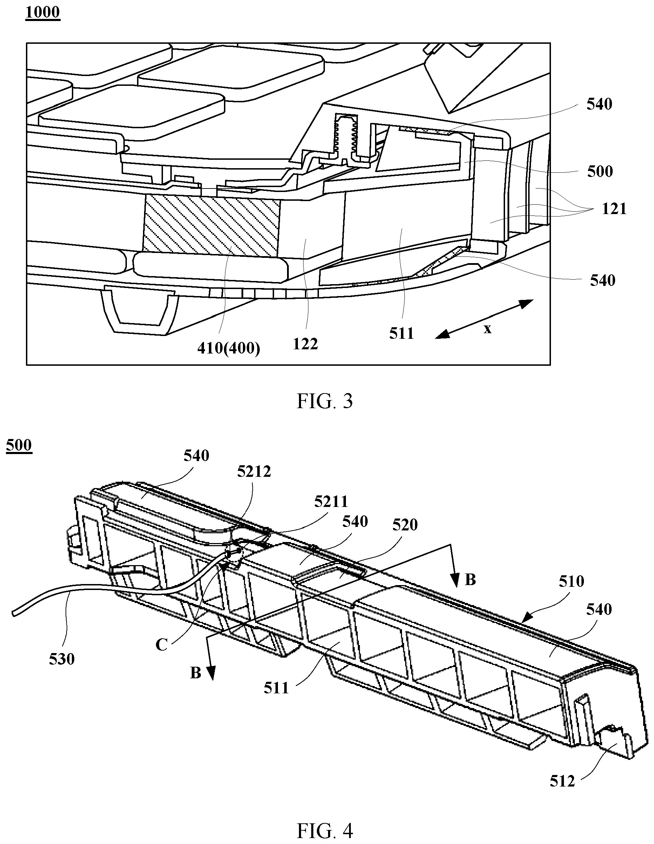

FIG. 3 is a partial section of the terminal device shown in FIG. 2 at A-A. As shown in FIG. 2 and FIG. 3, the heat dissipation module may include a fan and a heat dissipator 400. The fan is disposed in the air passage 122, with an air intake side of the fan facing the air inlets and an air exhaust side of the fan facing the air outlets. The heat dissipator 400 is thermally connected to the components that require heat dissipation, with heat dissipation fins 410 of the heat dissipator 400 located in the air passage. The fan may be configured to increase an airflow rate in the air passage. The heat dissipator 400 may absorb heat produced by components during operation, and exchange heat with air in the air passage 122 by using the heat dissipation fins 410, implementing cyclic heat dissipation for the components through flow of air.

After the overall structure of the terminal device is understood, the following specifically describes the antenna 500 in the terminal device. As described above, the antenna 500 is responsible for sending and receiving radio frequency signals. During actual application, the antenna 500 may be a type of antenna such as a circuit board antenna disposed on the circuit board, a border frame antenna disposed in a metal border frame of the first housing and/or a metal border frame of the second housing, an antenna based on a flexible printed circuit (flexible printed circuit, FPC), an antenna based on a laser-direct-structuring (laser-direct-structuring, LDS) technology, or a microstrip antenna (microstrip disk antenna, MDA). Certainly, in some embodiments, the terminal device 1000 may alternatively have a combination of a plurality of the types of antennas.

Among the various types of antennas, the LDS antenna is formed by employing a laser technology to perform electroless plating directly on a molded plastic substrate to form a metal antenna pattern, offering advantages such as being small in volume and flexible in design. A general procedure for producing an LDS antenna is as follows: injection-molding modified plastic that includes an organometallic compound, to obtain a substrate of a specific shape; irradiating a surface of the substrate with a laser, to obtain an activated region of a specific shape; then performing electroless copper plating in the activated region, to form copper plating; and then plating the copper plating with nickel and gold sequentially. After nickel plating, the antenna can be elastically connected to a spring directly, and after gold plating, the antenna can be soldered to a cable or another component. However, a nickel plating process and a gold plating process for the LDS antenna are complex and costly. These problems further limit application of the LDS antenna in terminal devices to some extent.

In view of this, an embodiment of this application provides an antenna that is based on an LDS technology. The antenna undergoes a specific surface treatment process, simplifying an antenna production process and reducing antenna production costs while ensuring that the antenna is corrosion-resistant.

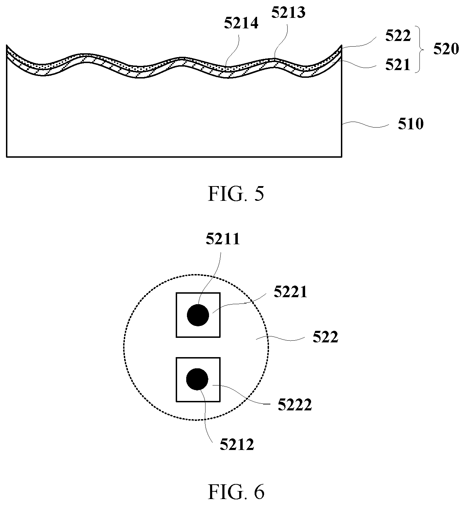

FIG. 4 is a diagram of a structure of an antenna 500 according to an embodiment of this application. FIG. 5 is a partial section of the antenna 500 shown in FIG. 4 at B-B. As shown in FIG. 4 and FIG. 5, in this embodiment of this application, the antenna 500 includes a substrate 510 and a radiator 520. The radiator 520 includes copper plating 521 and a passivation layer 522. The copper plating 521 is formed on a surface of the substrate 510 through electroless plating. The passivation layer 522 is provided on a surface of a side that is of the copper plating 521 and that faces away from the substrate 510. In other words, the passivation layer 522 covers the copper plating 521. Therefore, the passivation layer 522 can provide protective effect for the copper plating 521, reducing a risk that the copper plating 521 is corroded, and improving reliability of the antenna 500. In addition, compared with a manner of plating the copper plating 521 with nickel and gold in the conventional technology, a manner in this embodiment of this application is performing passivation treatment on the surface of the copper plating 521 to obtain the passivation layer 522. Therefore, a process for producing the antenna 500 is significantly simplified, and costs for producing the antenna 500 are also reduced.

In this embodiment, a material of the substrate 510 is modified plastic including an organometallic compound. After the surface of the substrate 510 is irradiated by a laser, the organometallic compound in an irradiated region on the surface of the substrate 510 releases metal particles. In this way, the irradiated region becomes an activated region. The copper plating 521 is formed in the activated region. For example, the material of the substrate 510 may be, but is not limited to, plastic such as polyamide, polycarbonate, or polyester.

In some embodiments, the passivation layer 522 may be an organic solderability preservative (organic solderability preservative, OSP). The organic solderability preservative has features such as oxidation resistance, thermal shock resistance, and moisture resistance, and can provide effective corrosion resistance for the copper plating 521. In addition, the organic solderability preservative can easily melt into solder paste during soldering, exposing the highly active copper plating 521. As such, the copper plating 521 can be reliably soldered to a feeder or another component, improving reliability of the antenna 500. Typically, the organic solderability preservative may be formed through immersion.

In some other embodiments, the passivation layer 522 may be a chemical conversion coating. The chemical conversion coating is also referred to as a metal conversion coating. Its protective function mainly relies on converting chemically active metal (for example, copper on the surface of the copper plating 521 in this embodiment of this application) into a chemically inactive metal compound, for example, an oxide, a chromate, or a phosphate, providing protective effect for the copper plating 521. The chemical conversion coating is formed through immersion, anodizing, spraying, brushing, or the like.

It should be noted that, after the passivation layer 522 is formed for the antenna 500 in this embodiment of this application, different from white resulting from nickel plating or golden yellow resulting from gold plating in the conventional technology, a surface of the passivation layer 522 is copper red, that is, a surface of a side that is of the radiator 520 and that faces away from the substrate 510 is copper red.

In this embodiment, the substrate 510 may be in a form of a support. For example, in the embodiments shown in FIG. 3 and FIG. 4, the substrate 510 is of a bar structure. The substrate 510 may be disposed at the air vent 121 in the second housing 120. In addition, the substrate 510 extends along a width direction x of the terminal device 1000, that is, a length direction of the substrate 510 is roughly parallel to the width direction x of the terminal device 1000. For example, the substrate 510 may be disposed at an air inlet or at an air outlet. The substrate 510 may be provided with one or more openings 511. When there are a plurality of openings 511, the plurality of openings 511 are arranged sequentially along the length direction of the substrate 510. At least one of the openings 511 in the substrate 510 may communicate with at least one of the air vents 121, so that air in the accommodating space can be discharged to the outside of the terminal device 1000 through the opening 511 and the air vent 121 sequentially, or air from the outside of the terminal device 1000 can enter the accommodating space through the air vent 121 and the opening 511 sequentially. It is easy to understand that, in this design, the at least one of the openings 511 that is in the substrate 510 and that communicates with the air vent 121 may serve as part of the air passage 122 in the accommodating space.

In an implementation, each opening 511 in the substrate 510 may communicate with at least one of the air vents 121. In this case, all the openings in the substrate 510 may form part of the air passage 122. For example, each opening 511 may be provided opposite one air vent 121. In this case, each opening 511 communicates with one air vent 121. Alternatively, each opening 511 may be provided opposite at least two air vents 121. In this case, each opening 511 communicates with at least two air vents 121.

In addition, two ends of the substrate 510 may each be provided with a mounting ear 512 along the length direction of the substrate 510. The substrate 510 may be fastened in the accommodating space in the second housing 120 by the mounting ears 512, to improve reliability of mounting the substrate 510 in the terminal device 1000, and further improve stability of the antenna 500.

In this embodiment of this application, surface regions of the substrate 510 except an inner wall of the opening 511 and surfaces of the mounting ears 512 may all be provided with the copper plating 521, that is, the copper plating 521 covers the entire surface of the substrate 510 except the inner wall of the opening 511 and the surfaces of the mounting ears 512. This design is equivalent to covering side walls of the opening 511 with the copper plating 521. Therefore, through proper design of a size of the opening 511, the opening 511 may be used as a resonant cavity for feeding. In other words, the antenna 500 provided in this embodiment of this application may serve as a cavity antenna. The cavity antenna has a low loss and offers advantages such as high radiation efficiency and stable performance, helping improve communication performance of the terminal device 1000.

In some other embodiments, the copper plating 521 may alternatively cover the surfaces of the mounting ears 512. In this case, the surface regions of the substrate 510 except the inner wall of the opening 511 are all provided with the copper plating 521.

As shown in FIG. 4 and FIG. 5, in this embodiment of this application, the antenna 500 further includes a coaxial cable 530. One end of an inner conductor of the coaxial cable 530 is electrically connected to a feed point 5211 of the radiator 520, and one end of an outer conductor of the coaxial cable 530 is electrically connected to a ground point 5212 of the radiator 520. The other end of the inner conductor of the coaxial cable 530 is electrically connected to a radio frequency chip, and the other end of the outer conductor of the coaxial cable 530 is grounded. In this way, the coaxial cable 530 is utilized to transfer radio frequency signals between the radio frequency chip and the antenna 500. For example, the other end of the outer conductor of the coaxial cable 530 may be grounded by being electrically connected to a ground line of a circuit board or to a ground component inside the terminal device. In this embodiment, the feed point 5211 and the ground point 5212 of the radiator 520 are separately provided on the copper plating 521. The coaxial cable 530 may be electrically connected to the copper plating 521 through soldering.

In an implementation, when the passivation layer 522 is an organic solderability preservative, based on properties of a material of the organic solderability preservative, the one end of the inner conductor of the coaxial cable 530 may be soldered directly to a region that is of the passivation layer 522 and that is opposite a position of the feed point 5211. In a case of low-temperature solder paste or normal-temperature solder paste, a material of the passivation layer 522 in the region can melt into the solder paste, enabling the inner conductor of the coaxial cable 530 to be reliably connected to the feed point 5211. Likewise, the one end of the outer conductor of the coaxial cable 530 may be soldered directly to a region that is of the passivation layer 522 and that is opposite a position of the ground point 5212, enabling the outer conductor of the coaxial cable 530 to be reliably connected to the ground point 5212.

In an implementation, when the passivation layer 522 is a chemical conversion coating, refer to FIG. 4 and FIG. 6 together. FIG. 6 is a partial enlarged view of a region C in FIG. 4. The passivation layer 522 may include a first hollowed-out region 5221 and a second hollowed-out region 5222. The first hollowed-out region 5221 may be used to expose the feed point 5211, and the second hollowed-out region 5222 may be used to expose the ground point 5212. In a case of low-temperature solder paste or normal-temperature solder paste, the inner conductor of the coaxial cable 530 may be soldered directly to the feed point 5211, and the outer conductor of the coaxial cable 530 may be soldered directly to the ground point 5212, enabling the coaxial cable 530 to be reliably connected to the radiator 520. The first hollowed-out region 5221 and the second hollowed-out region 5222 may be formed through processes such as grinding, sandblasting, and laser engraving.

In addition, in the two implementations, the antenna 500 may further include a first adhesive body and a second adhesive body. The first adhesive body coats a solder joint between the inner conductor of the coaxial cable 530 and the feed point 5211, and the second adhesive body coats a solder joint between the outer conductor of the coaxial cable 530 and the ground point 5212. The first adhesive body and the second adhesive body may be separately formed through an adhesive dispensing process. The first adhesive body and the second adhesive body can provide protective effect for the corresponding solder joints respectively, improving reliability of connection between the coaxial cable 530 and the radiator 520, and further improving operational reliability of the antenna 500.

As shown in FIG. 4, in this embodiment of this application, electrically conductive foam 540 may be disposed on the surface of the side that is of the radiator 520 and that faces away from the substrate, and a region in which the radiator 520 and the electrically conductive foam are in contact with each other is electrically conductive. For example, resistance in the region in which the radiator 520 and the electrically conductive foam 540 are in contact with each other may be 0.2 Ω, 0.13 Ω, 0.1 Ω, 0.05 Ω, 0.03 Ω, or the like. With reference to FIG. 3, when the antenna 500 is mounted in the terminal device 1000, the radiator 520 may be electrically connected to the ground component inside the terminal device 1000 via the electrically conductive foam 540. In this way, the antenna 500 is grounded. The ground component may be a housing of the terminal device 1000. For example, when the antenna 500 is disposed in the second housing 120, the electrically conductive foam 540 may be disposed on surfaces of a plurality of sides of the radiator 520 separately. In this way, the surfaces of the plurality of sides of the radiator 520 may be electrically connected to an inner wall of the second housing 120 via the corresponding electrically conductive foam 540, respectively, ensuring reliability of grounding of the antenna 500.

As shown in FIG. 4 and FIG. 5, in this embodiment of this application, the surface of the side that is of the copper plating 521 and that faces away from the substrate may be rough to some extent, so that the surface of the copper plating 521 exhibits an uneven structural condition on a microscopic scale. In this case, the surface of the side that is of the copper plating 521 and that faces away from the substrate includes a plurality of protrusions 5213 and a plurality of recesses 5214 formed between adjacent protrusions 5213. During a process of forming the passivation layer 522 on the copper plating 521, based on characteristics of a process for forming the passivation layer structure, a material used for producing the passivation layer 522 exhibits unevenness across different positions on the surface of the copper plating 521, resulting in that thicknesses of the formed passivation layer 522 are not the same. The thicknesses being not the same is specifically presented as that a thickness of the passivation layer 522 in a region corresponding to the protrusion 5213 is less than a thickness of the passivation layer 522 in a region corresponding to the recess 5214.

Because the passivation layer 522 in the region corresponding to the protrusion 5213 is relatively thin, after the electrically conductive foam is disposed on the surface of the radiator 520, the passivation layer 522 in the region corresponding to the protrusion 5213 can be easily worn through by the electrically conductive foam, exposing the underlying copper plating 521. For the passivation layer 522 in the region corresponding to the recess 5214, because the passivation layer 522 in the region is relatively thick and is in relatively poor contact with the electrically conductive foam, the passivation layer 522 in the region can still be well attached to the copper plating 521. In other words, in the region in which the radiator 520 is in contact with the electrically conductive foam, some portions that are of the copper plating 521 and that are exposed because the passivation layer 522 is worn through can be utilized to implement conduction of electricity, and protection provided by the passivation layer 522 for remaining portions of the copper plating 521 can also be ensured, implementing a balance between corrosion resistance and conduction of electricity of the radiator 520.

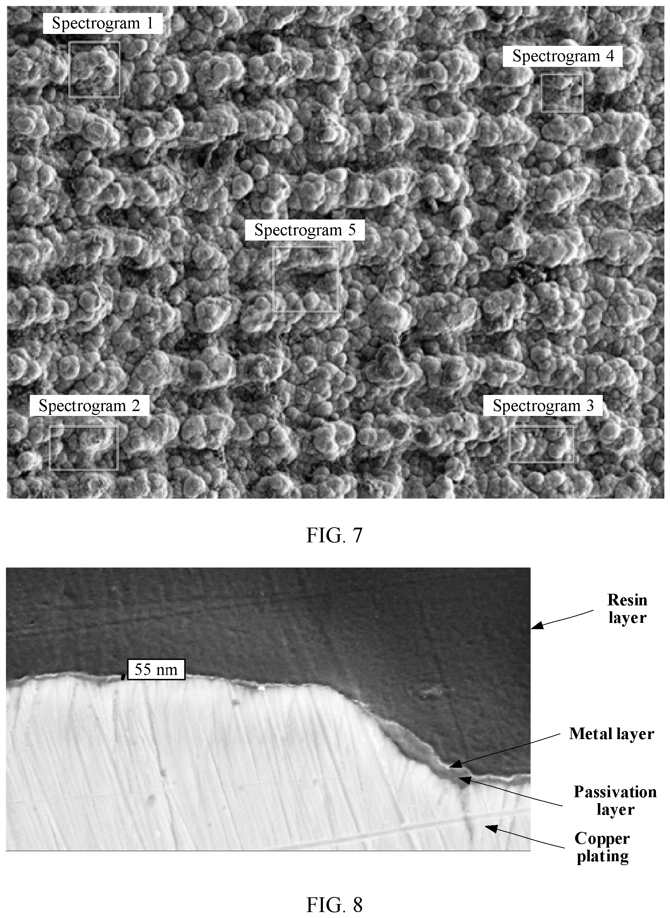

FIG. 7 is a diagram of a structure of the surface of the side that is of the copper plating 521 and that faces away from the substrate under an electron microscope according to an embodiment of this application. A roughness condition exhibited by the surface of the copper plating 521 on the microscopic scale can be learned from FIG. 7. In this embodiment, surface roughness of the surface of the side that is of the copper plating 521 and that faces away from the substrate is greater than or equal to 1 um. For example, the surface roughness of the surface of the side that is of the copper plating 521 and that faces away from the substrate may be 1 um, 1.2 um, 1.5 um, 2 um, 2.3 um, or the like. It is verified that the copper plating 521 meeting the surface roughness condition can not only enable the passivation layer formed subsequently to resist corrosion, but also ensure that resistance of the surface of the radiator is low, balancing corrosion resistance and conduction of electricity of the radiator.

FIG. 8 is a diagram of a section structure of a radiator test sample under an electron microscope according to an embodiment of this application. Herein, the radiator test sample is a test sample obtained after a radiator is processed for clearer and more accurate observation of structures of layers of the radiator. Compared with the radiator provided in this embodiment of this application, the radiator test sample further includes a metal layer and a resin layer that are provided on a surface of the radiator sequentially. The metal layer is provided for facilitating observation of a passivation layer, while the resin layer is provided for facilitating cutting of the radiator test sample. It should be noted that the radiator test sample is for testing purposes only, and during actual application, a radiator does not include the metal layer or the resin layer. As shown in FIG. 8, from bottom to top, layers of the section structure are copper plating, the passivation layer, the metal layer, and the resin layer sequentially. It can be learned that a thickness of the passivation layer in a region corresponding to a protrusion is significantly less than a thickness of the passivation layer in a region corresponding to a recess. In this embodiment, a thickness of the passivation layer is greater than or equal to 50 nm and less than or equal to 1000 nm. For example, a thickness of the passivation layer in a region corresponding to a protrusion may be approximately 50 nm or slightly greater than 50 nm. For example, a thickness of the passivation layer at a position indicated in the figure is approximately 55 nm. A thickness of the passivation layer in a region corresponding to a recess may be approximately 1000 nm or slightly less than 1000 nm. In this way, it can be ensured that conduction of electricity is implemented because the passivation layer in a region corresponding to a protrusion is easy to wear through, and it can also be ensured that the passivation layer in a region corresponding to a recess can implement corrosion resistance due to a relatively large thickness.

With reference to FIG. 4 and FIG. 5 again, based on a same inventive concept, an embodiment of this application further provides a method for producing an antenna 500. The method includes: forming a radiator 520 on a surface of a substrate 510. Forming the radiator 520 on the surface of the substrate 510 may include the following steps:
forming copper plating 521 on the surface of the substrate 510; and
forming a passivation layer 522 on a surface of a side that is of the copper plating 521 and that faces away from the substrate.

For the antenna 500 produced by using the foregoing method, the passivation layer 522 covers the copper plating 521. Therefore, the passivation layer 522 can provide protective effect for the copper plating 521, reducing a risk that the copper plating 521 is corroded, and improving reliability of the antenna 500. In addition, compared with a manner of plating the copper plating 521 with nickel and gold in the conventional technology, a manner in this embodiment of this application is performing passivation treatment on the surface of the copper plating 521 to obtain the passivation layer 522. Therefore, a process for producing the antenna 500 is significantly simplified, and costs for producing the antenna 500 are also reduced.

In some embodiments, before forming the copper plating 521 on the surface of the substrate 510, the production method further includes:
performing injection molding to form the substrate 510, and performing laser engraving on the surface of the substrate 510 to form an activated region.

A material of the substrate 510 may be modified plastic that includes an organometallic compound. For example, the material of the substrate 510 may be, but is not limited to, plastic such as polyamide, polycarbonate, or polyester.

In some embodiments, after forming the passivation layer 522 on the surface of the side that is of the copper plating 521 and that faces away from the substrate 510, the production method may further include:
soldering a feed point 5211 of the radiator 520 to one end of an inner conductor of a coaxial cable 530, and soldering a ground point 5212 of the radiator 520 to one end of an outer conductor of the coaxial cable 530. The other end of the inner conductor of the coaxial cable 530 is electrically connected to a radio frequency chip, and the other end of the outer conductor of the coaxial cable 530 is grounded. In this way, the coaxial cable 530 is utilized to transfer radio frequency signals between the radio frequency chip and the radiator 520.

In addition, after soldering the feed point 5211 of the radiator 520 to the one end of the inner conductor of the coaxial cable 530, the production method may further include:
dispensing adhesive at a solder joint between the feed point 5211 and the inner conductor of the coaxial cable 530, to form a first adhesive body that coats the solder joint between the feed point 5211 and the inner conductor of the coaxial cable 530. In this way, the first adhesive body is utilized to provide protection for the solder joint.

Likewise, after soldering the ground point 5212 of the radiator 520 to the one end of the outer conductor of the coaxial cable 530, the production method may further include:
dispensing adhesive at a solder joint between the ground point 5212 and the outer conductor of the coaxial cable 530, to form a second adhesive body that coats the solder joint between the ground point 5212 and the outer conductor of the coaxial cable 530. In this way, the second adhesive body is utilized to provide protection for the solder joint.

In this embodiment, the passivation layer 522 may be an organic solderability preservative or a chemical conversion coating. Both types of the passivation layer can provide good corrosion resistance for the copper plating. By using the two types of the passivation layer as examples, the following describes in detail two methods for producing the antenna 500.

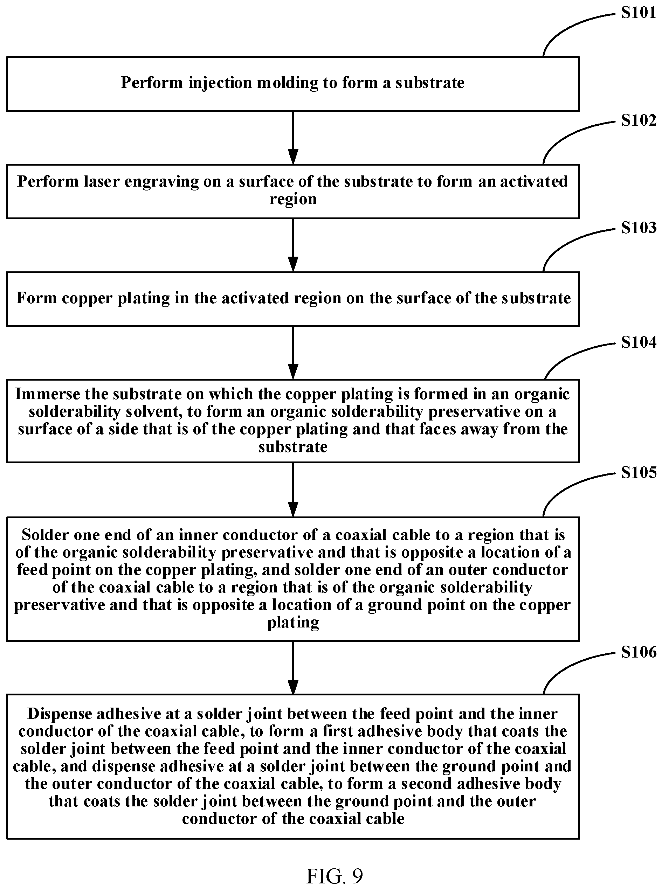

First, FIG. 9 is a flowchart of an antenna production method according to an embodiment of this application. The production method includes the following steps.

S101: Perform injection molding to form a substrate. In this embodiment, the substrate may be of a bar structure. Along a length direction of the substrate, the substrate is provided with one or more openings. The substrate may be disposed at an air vent in a housing of a terminal device, with each opening in the substrate communicating with at least one of the air vents. The opening in the substrate may serve as part of an air passage.

S102: Perform laser engraving on a surface of the substrate to form an activated region. After the surface of the substrate is irradiated by a laser, an organometallic compound in an irradiated region on the surface of the substrate releases metal particles. In this way, the irradiated region becomes the activated region.

S103: Form copper plating in the activated region on the surface of the substrate. During specific implementation, the copper plating may be formed through electroless plating.

S104: Immerse the substrate on which the copper plating is formed in an organic solderability solvent, to form an organic solderability preservative on a surface of a side that is of the copper plating and that faces away from the substrate.

S105: Solder one end of an inner conductor of a coaxial cable to a region that is of the organic solderability preservative and that is opposite a position of a feed point on the copper plating, and solder one end of an outer conductor of the coaxial cable to a region that is of the organic solderability preservative and that is opposite a position of a ground point on the copper plating. The organic solderability preservative provides good solderability. In a case of low-temperature solder paste or normal-temperature solder paste, the regions that are of the organic solderability preservative and that are opposite the positions of the feed point and the ground point can melt into the solder paste, enabling the coaxial cable to be reliably connected to a radiator.

S106: Dispense adhesive at a solder joint between the feed point and the inner conductor of the coaxial cable, to form a first adhesive body that coats the solder joint between the feed point and the inner conductor of the coaxial cable, and dispense adhesive at a solder joint between the ground point and the outer conductor of the coaxial cable, to form a second adhesive body that coats the solder joint between the ground point and the outer conductor of the coaxial cable. The first adhesive body and the second adhesive body can provide protective effect for the corresponding solder joints respectively, improving reliability of connection between the coaxial cable and the radiator, and further improving operational reliability of the antenna.

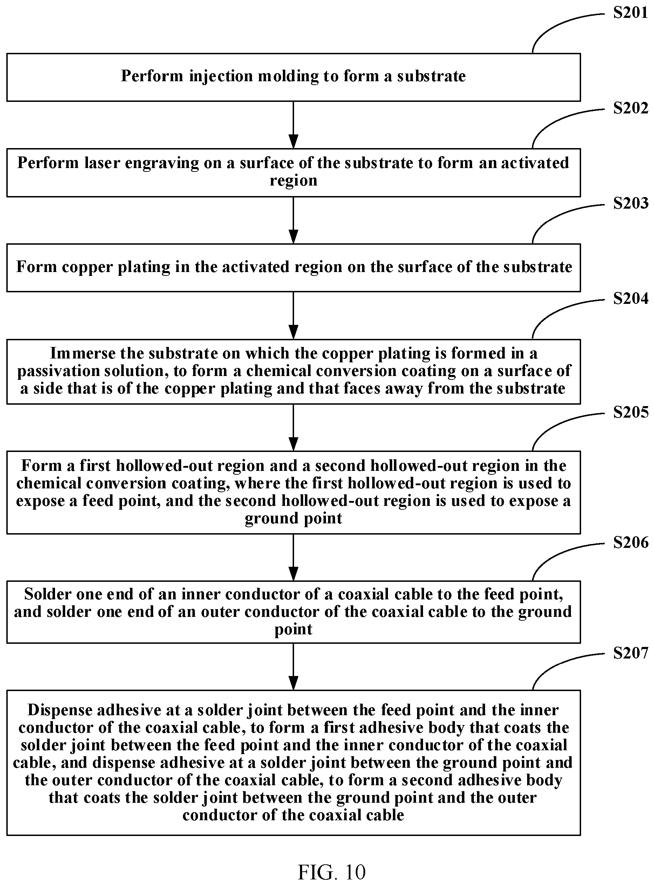

FIG. 10 is a flowchart of another antenna production method according to an embodiment of this application. The production method includes the following steps.

S201: Perform injection molding to form a substrate. In this embodiment, the substrate may be of a bar structure. Along a length direction of the substrate, the substrate is provided with one or more openings. The substrate may be disposed at an air vent in a housing of a terminal device, with at least one of the openings in the substrate communicating with at least one of the air vents. The opening communicating with the air vent may serve as part of an air passage.

S202: Perform laser engraving on a surface of the substrate to form an activated region. After the surface of the substrate is irradiated by a laser, an organometallic compound in an irradiated region on the surface of the substrate releases metal particles. In this way, the irradiated region becomes the activated region.

S203: Form copper plating in the activated region on the surface of the substrate. During specific implementation, the copper plating may be formed through electroless plating.

S204: Immerse the substrate on which the copper plating is formed in a passivation solution, to form a chemical conversion coating on a surface of a side that is of the copper plating and that faces away from the substrate.

S205: Form a first hollowed-out region and a second hollowed-out region in the chemical conversion coating, where the first hollowed-out region is used to expose a feed point, and the second hollowed-out region is used to expose a ground point. The first hollowed-out region and the second hollowed-out region may be formed through processes such as grinding, sandblasting, and laser engraving.

S206: Solder one end of an inner conductor of a coaxial cable to the feed point, and solder one end of an outer conductor of the coaxial cable to the ground point.

S207: Dispense adhesive at a solder joint between the feed point and the inner conductor of the coaxial cable, to form a first adhesive body that coats the solder joint between the feed point and the inner conductor of the coaxial cable, and dispense adhesive at a solder joint between the ground point and the outer conductor of the coaxial cable, to form a second adhesive body that coats the solder joint between the ground point and the outer conductor of the coaxial cable. The first adhesive body and the second adhesive body can provide protective effect for the corresponding solder joints respectively, improving reliability of connection between the coaxial cable and the radiator, and further improving operational reliability of the antenna.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. An antenna, comprising a substrate and a radiator, wherein the radiator comprises copper plating and a passivation layer, the copper plating is formed on a surface of the substrate, and the passivation layer is provided on a surface of a side that is of the copper plating and that faces away from the substrate.

2. The antenna according to claim 1, wherein electrically conductive foam is disposed on a surface of a side that is of the radiator and that faces away from the substrate, and a region in which the radiator and the electrically conductive foam are in contact with each other is electrically conductive.

3. The antenna according to claim 2, wherein the surface of the side that is of the copper plating and that faces away from the substrate comprises a plurality of protrusions and a plurality of recesses formed between adjacent protrusions, and a thickness of the passivation layer in a region corresponding to the protrusion is less than a thickness of the passivation layer in a region corresponding to the recess.

4. The antenna according to claim 2 or 3, wherein surface roughness of the surface of the side that is of the copper plating and that faces away from the substrate is greater than or equal to 1 um.

5. The antenna according to any one of claims 1 to 4, wherein a thickness of the passivation layer is greater than or equal to 50 nm and less than or equal to 1000 nm.

6. The antenna according to any one of claims 1 to 5, wherein the antenna further comprises a coaxial cable; and the radiator comprises a feed point and a ground point that are provided on the copper plating, the feed point is electrically connected to one end of an inner conductor of the coaxial cable, and the ground point is electrically connected to one end of an outer conductor of the coaxial cable.

7. The antenna according to claim 6, wherein the passivation layer is an organic solderability preservative.

8. The antenna according to claim 7, wherein the one end of the inner conductor of the coaxial cable is soldered to a region that is of the passivation layer and that is opposite a position of the feed point, and the one end of the outer conductor of the coaxial cable is soldered to a region that is of the passivation layer and that is opposite a position of the ground point.

9. The antenna according to claim 6, wherein the passivation layer is a chemical conversion coating.

10. The antenna according to claim 9, wherein the passivation layer comprises a first hollowed-out region and a second hollowed-out region, the feed point is exposed in the first hollowed-out region, and the ground point is exposed in the second hollowed-out region; and
the one end of the inner conductor of the coaxial cable is soldered to the feed point, and the one end of the outer conductor of the coaxial cable is soldered to the ground point.

11. The antenna according to any one of claims 1 to 10, wherein the surface of the side that is of the radiator and that faces away from the substrate is copper red.

12. A terminal device, comprising a housing and a radio frequency module disposed in the housing, wherein the radio frequency module comprises a radio frequency chip and the antenna according to any one of claims 1 to 11, and the radio frequency chip is connected to the radiator.

13. The terminal device according to claim 12, wherein the housing is provided with one or more air vents; and the antenna is disposed at the air vent, the substrate is provided with one or more openings, and at least one of the openings communicates with at least one of the air vents.

14. An antenna production method, comprising forming a radiator on a surface of a substrate, wherein forming the radiator on the surface of the substrate comprises:
forming copper plating on the surface of the substrate; and
forming a passivation layer on a surface of a side that is of the copper plating and that faces away from the substrate.

15. The production method according to claim 14, wherein forming the passivation layer on the surface of the side that is of the copper plating and that faces away from the substrate specifically comprises:
immersing the substrate on which the copper plating is formed in an organic solderability solvent, to form an organic solderability preservative on the surface of the side that is of the copper plating and that faces away from the substrate.

16. The production method according to claim 14, wherein forming the passivation layer on the surface of the side that is of the copper plating and that faces away from the substrate specifically comprises:
immersing the substrate on which the copper plating is formed in a passivation solution, to form a chemical conversion coating on the surface of the side that is of the copper plating and that faces away from the substrate.
